## Europäisches Patentamt

## European Patent Office

## Office européen des brevets

(19)

(11) Veröffentlichungsnummer: **0 127 005**
**B1**

(12) # EUROPÄISCHE PATENTSCHRIFT

(45) Veröffentlichungstag der Patentschrift:
**05.11.86**

(51) Int. Cl.⁴: **H 01 R 11/18,** G 01 R 1/067

(21) Anmeldenummer: **84104904.2**

(22) Anmeldetag: **02.05.84**

(54) **Prüfnadel für ein Prüfgerät zum Prüfen von Leiterplatten.**

(30) Priorität: **03.05.83 DE 3316103**

(43) Veröffentlichungstag der Anmeldung:
**05.12.84 Patentblatt 84/49**

(45) Bekanntmachung des Hinweises auf die Patenterteilung:
**05.11.86 Patentblatt 86/45**

(84) Benannte Vertragsstaaten:
**DE FR GB IT NL SE**

(56) Entgegenhaltungen:
**EP-A-0 021 697**
**EP-A-0 068 986**
**DE-A-2 937 883**

**TECHNICAL DIGEST, Nr. 57, Januar 1980, New York, USA; V.M. HOOVER "Mass verification gauge", Seiten 11,12**

(73) Patentinhaber: **Nixdorf Computer Aktiengesellschaft, Fürstenallee 7, D-4790 Paderborn (DE)**

(72) Erfinder: **Frers, Klaus-Dieter, Dipl.-Ing., Antoniusstrasse 6, D-4795 Delbrück (DE)**
Erfinder: **Liekmeier, Josef, Amtsweg 48, D-4790 Paderborn (DE)**

(74) Vertreter: **Patentanwälte Schaumburg & Thoenes, Mauerkircherstrasse 31 Postfach 86 07 48, D-8000 München 80 (DE)**

## Beschreibung

Die Erfindung betrifft eine Prüfnadel für ein Prüfgerät zum Prüfen von Leiterplatten, umfassend einen Nadelschaft mit einem Kopf.

Ein derartiges Prüfgerät umfaßt entsprechend der Anzahl von Lötstellen an einer Leiterplatte oft hunderte derartiger Prüfnadeln, die in Längsrichtung des Schaftes geführt sind und mit ihrem dem Kopf fernen Ende einen Gerätekontakt berühren, während sie mit dem Nadelkopf an einer Lötstelle der Leiterplatte anliegen. Bei bekannten Nadeln ist der im wesentlichen zylindrische und mit einer kegelförmigen Spitze versehene Kopf mit dem Nadelschaft verschweißt. Dadurch ist die Herstellung der Nadeln relativ aufwendig. Durch das getrennte Herstellen des Schaftes und des Kopfes sowie durch das Verschweißen der beiden Teile ist der Herstellungspreis für derartige Prüfnadeln relativ hoch, was bei der großen Anzahl an benötigten Nadeln ins Gewicht fällt.

Der Erfindung liegt die Aufgabe zugrunde, eine Prüfnadel der eingangs genannten Art anzugeben, die einfach und preiswert herzustellen ist.

Diese Aufgabe wird erfindungsgemäß dadurch gelöst, daß der Kopf von einem abgeflachten, ein scharfkantiges Kontaktprofil aufweisenden Endabschnitt des Nadelschaftes gebildet ist.

Der Kopfabschnitt der Prüfnadel kann somit auf einfache Weise beispielsweise durch Prägen hergestellt werden, und zwar vorzugsweise in einem Gesenk, das nicht nur den Kopfabschnitt abflacht, sondern gleichzeitig auch das Kontaktprofil formt, so daß ein Anschleifen des Kopfabschnittes entfallen kann. Der Herstellungspreis für eine derartige Prüfnadel beträgt ca. 10 % des Herstellungspreises für eine herkömmliche Prüfnadel, so daß sich bei der großen Anzahl von benötigten Prüfnadeln eine erhebliche Einsparung ergibt. Darüber hinaus ist ein Prüfgerät mit den erfindungsgemäßen Prüfnadeln leichter zu bestücken. Das Bestücken erfolgt nämlich in der Weise, daß man auf eine Lochplatte, deren Lochmuster dem Lötstellenmuster der zu prüfenden Leiterplatte entspricht, ein Bündel der Prüfnadeln aufsetzt und durch Hin- und Herbewegen des Bündels die Prüfnadeln in die Löcher einführt, um nicht jede Nadel einzeln durch ein Loch stecken zu müssen. Bei den herkömmlichen Prüfnadeln können diese nicht parallel zueinander im Bündel liegen, da durch die radial breiteren Köpfe das Bündel am oberen Ende wesentlich weiter als am unteren Ende ist. Bei den erfindungsgemäßen Prüfnadeln ragt dagegen der Kopf höchstens in einer Richtung radial über den Nadelschaft hinaus, so daß die Prüfnadeln in dem Bündel weitgehend parallel liegen und somit leichter in die Führungsbohrungen der Lochplatte hineinfallen.

Um eine gute Kontaktierung sicherzustellen, weist der Kopf zweckmäßigerweise ein scharfkantiges Kontaktprofil auf, das durch Schleifen oder beim Prägevorgang erzielt werden kann. Das Kontaktprofil kann beispielsweise von zwei unter einem Winkel dachartig gegeneinander geneigten Kanten gebildet sein, wobei der Winkel zwischen den Kanten zweckmäßigerweise ca. 120° beträgt. Die Kanten können geradlinig oder auch konkav oder konvex gekrümmt sein. Das Kontaktprofil kann auch mehrere Spitzen aufweisen.

Um zu vermeiden, daß die Prüfnadeln aus der Führungsplatte herausfallen oder beim Abnehmen der zu prüfenden Leiterplatte an dieser hängen bleiben und dabei herausgezogen werden, wird vorgeschlagen, daß der Nadelschaft in einem mittleren Bereich eine Verbreiterung aufweist, die vorzugsweise ca. 20% des Schaftdurchmessers beträgt. Die Verbreiterung kann beispielsweise ebenfalls durch Prägen hergestellt werden, so daß diese Verbreiterung und der Kopfabschnitt in einem Arbeitsgang erzeugt werden können. Gegebenenfalls kann aber auch die Verbreiterung durch Stauchen des Nadelschaftes erzeugt werden. Die Größe der Verbreiterung ist in jedem Falle so gewählt, daß die Nadel mit einem gewissen Druck durch die Führungsbohrung hindurchgeschoben und unter Kraftaufwendung auch wieder aus der Führungsbohrung herausgezogen werden kann, während ein Herausfallen der Nadel aus der Führungsbohrung durch diese Verbreiterung zuverlässig verhindert wird.

Weitere Vorteile der Erfindung ergeben sich aus der folgenden Beschreibung, welche in Verbindung mit den beigefügten Zeichnungen die Erfindung anhand von Ausführungsbeispielen erläutert. Darin zeigen:

Fig. 1 eine schematische seitliche Teilansicht einer Prüfvorrichtung unter Verwendung einer erfindungsgemäßen Prüfnadel,

Fig. 2 eine Seitenansicht einer erfindungsgemäßen Prüfnadel gemäß einer ersten Ausführungsform der Erfindung,

Fig. 3 eine Ansicht der in der Fig. 2 dargestellten Prüfnadel in Richtung des Pfeiles A in Fig. 2,

Fig. 4 eine der Fig. 2 entsprechende Ansicht einer Prüfnadel gemäß einer zweiten Ausführungsform der Erfindung mit einem verdickten Nadelschaft,

Fig. 5 eine der Fig. 3 entsprechende Ansicht der in Fig. 4 dargestellten Ausführungsform und

Fig. 6 bis 15 verschiedene Ausführungsformen von Verdickungen oder Verbreiterungen des Nadelschaftes an einer erfindungsgemäßen Prüfnadel.

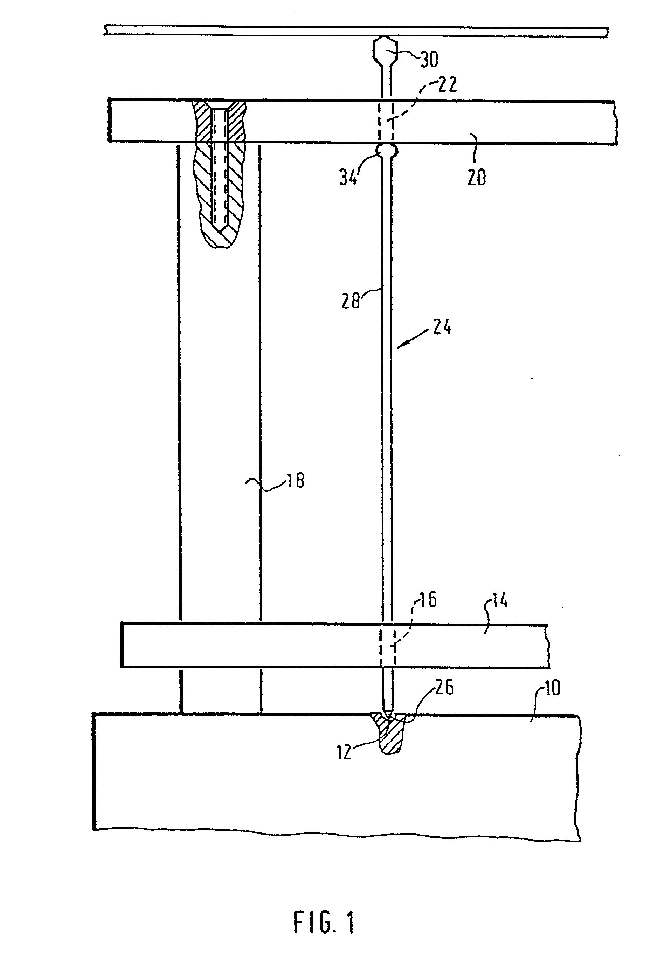

In Fig. 1 ist der prinzipielle Aufbau eines Prüfgerätes zum Prüfen von Leiterplatten dargestellt, in dem die erfindungsgemäßen Prüfnadeln verwendet werden sollen. Das Prüfgerät umfaßt einen Sockel 10 mit Kontaktstellen 12, die im Rastermaß der Leiterplatten angeordnet sind und in nicht dargestellter Weise mit einer Prüfschaltung verdrahtet sind. In einem Abstand oberhalb des Sockels befindet sich eine Führungsplatte 14, die ein dem Raster der Leiterplatten entsprechendes Bohrungsmuster aufweist, wobei die einzelnen Bohrungen 16 mit den jeweiligen Kontaktstellen 12 im Sockel 10 fluchten. Oberhalb der Führungsplatte 14 und durch Stützen 18 in einem Abstand von und parallel zu dieser angeordnet befindet sich eine weitere Führungsplatte 20, mit Bohrungen 22, deren Muster dem der Lötstellen der zu prüfenden Leiterplatte entspricht und die mit den Bohrungen 16 und den Kontaktstellen 12 in der unteren Führungsplatte 14 bzw. dem Sockel 10 fluchten.

Die so beschriebene Anordnung wird mit Prüfnadeln 24 bestückt, welche die Bohrungen 22 und 16 durchsetzen und mit ihrem unteren, spitz angeschliffenen Ende 26 auf den Kontaktstellen 12 aufstehen.

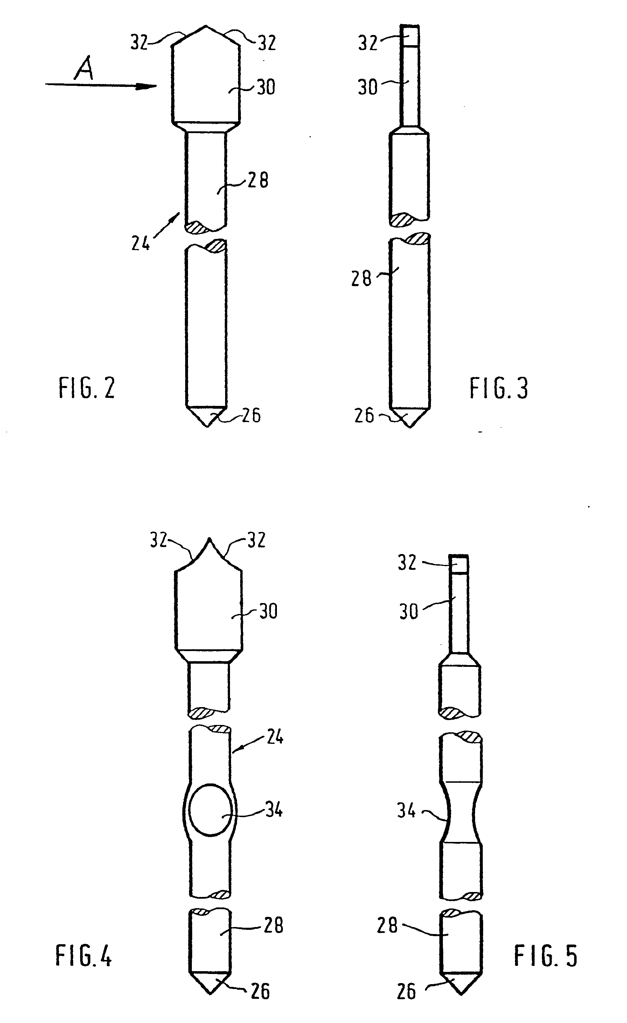

Die Fig. 2 und 3 zeigen dabei eine erste Ausführungsform der erfindungsgemäßen Prüfnadel im vergrößerten Maßstab. Die Prüfnadel umfaßt einen Schaft 28, der an seinem unteren Ende die Spitze 26 trägt und an seinem oberen Ende unter Bildung eines Kopfes 30 abgeflacht ist. Dabei ragt der abgeflachte Abschnitt in der einen Richtung radial über den Schaft 28 hinaus, wie man dies in Fig. 2 erkennt. Der Kopf 30 ist an seinem oberen Ende unter Bildung zweier scharfer Kontaktkanten 32 angeschliffen. Die Kontaktkanten bilden vorzugsweise einen Winkel von ca. 120° miteinander, wobei jedoch auch kleinere oder größere Winkel denkbar sind. Aus Kostengründen wird der Kopf 30 vorzugsweise durch Prägen hergestellt. Es wäre jedoch auch denkbar, den Kopf durch Fräsen zu erzeugen, jedoch ist dieses Herstellungsverfahren teurer.

Die Fig. 4 und 5 zeigen eine zweite Ausführungsform der erfindungsgemäßen Prüfnadel, die sich von der ersten Ausführungsform zunächst dadurch unterscheidet, daß die Kontaktkanten 32 am Kopf 30 nicht geradlinig sondern konkav gekrümmt sind. Es wäre auch denkbar, diese Kanten konvex zu krümmen.

Zum weiteren unterscheidet sich die Prüfnadel gemäß den Fig. 4 und 5 dadurch, daß der Nadelschaft eine Verdickung oder Verbreiterung 34 aufweist, die vorzugsweise ebenfalls durch Prägen erzeugt wird, wobei in der zu der Verbreiterung senkrechten Richtung eine Durchmesserverminderung des Nadelschaftes erfolgt, wie man dies in Fig. 5 erkennt. Der größte Durchmesser des verbreiterten Abschnittes 34 ist etwa 20% größer als der Durchmesser des übrigen Nadelschaftes 28.

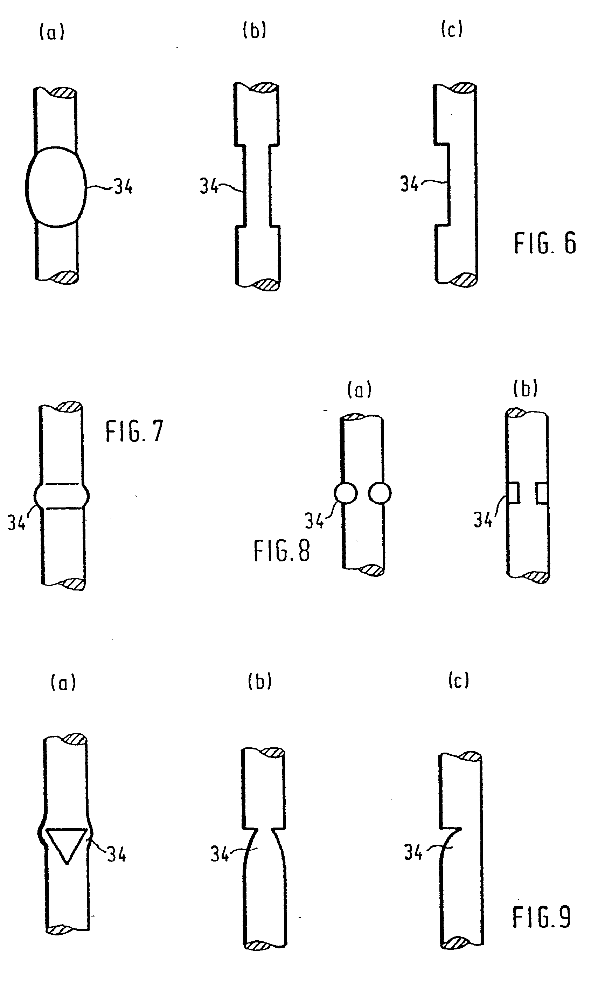

Die Fig. 6a zeigt in einer Frontalansicht eine weitere Ausführungsform einer durch Prägen erzeugten Verbreiterung des Nadelschaftes 28. Die Fig. 6b und 6c zeigen die in der Fig. 6a dargestellte Ausführungsform jeweils in einer Seitenansicht mit beidseitiger Prägung (Fig. 6b) bzw. einseitiger Prägung (Fig. 6c).

Fig. 7 zeigt eine Verbreiterung des Nadelschaftes 28, die durch Stauchen des Nadelschaftes in Längsrichtung erreicht wurde.

Die Fig. 8a und 8b zeigen den Fig. 6a und 6b entsprechende Ansichten einer weiteren Ausführungsform einer durch Prägen sowohl einseitig als auch beidseitig anzubringenden Verbreiterung des Nadelschaftes 28.

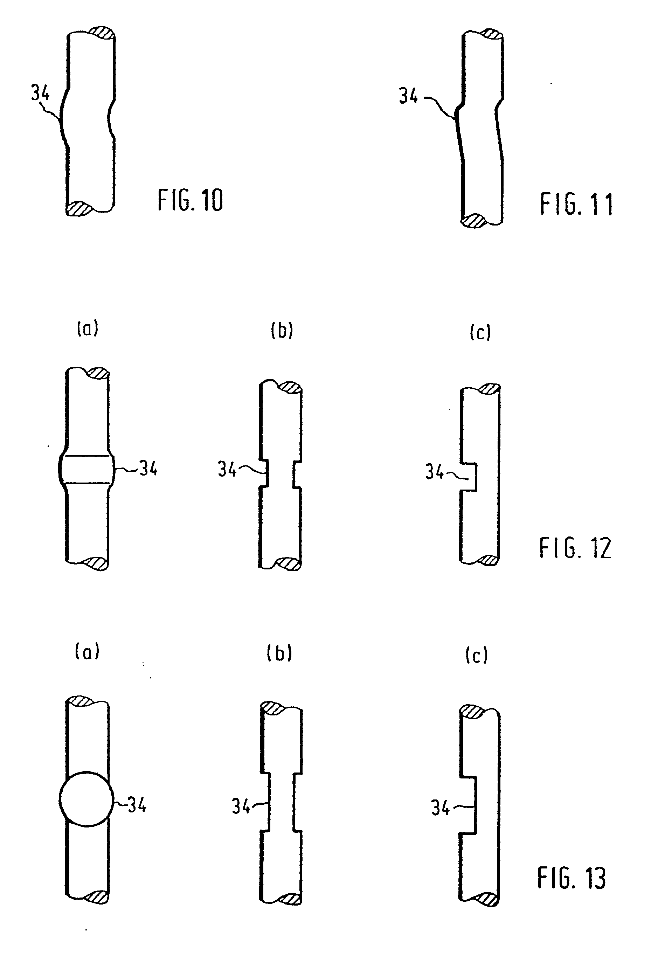

Die Fig. 9 zeigt der Fig. 6 entsprechende Ansichten einer weiteren Ausführungsform einer durch Prägen erzielten Verbreiterung des Nadelschaftes 28.

Die Fig. 10 und 11 zeigen jeweils eine Verdickung des Nadelschaftes 28, die durch eine lokale Auslenkung des Nadelschaftes von der geraden Zylinderform erzielt wird.

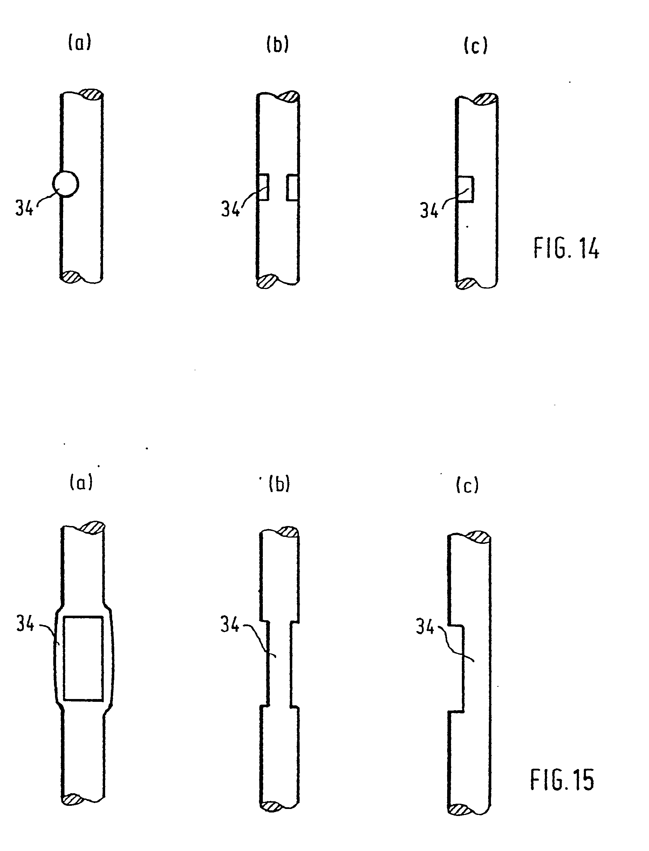

Die Fig. 12 bis 15 zeigen weitere den Ansichten in Fig. 6 entsprechende Ansichten von Nadelschäften 28, bei denen eine Verbreiterung derselben durch Prägen erzielt wurde.

Die Verbreiterung 34 des Nadelschaftes befindet sich in einem Abstand von dem Nadelkopf 30, der mindestens gleich der Dicke der oberen Führungsplatte 20 ist. Wie die Fig. 1 zeigt, kann die Verdickung 34 so angeordnet sein, daß sie annähernd an der Unterseite der Führungsplatte 20 anliegt, wenn die Prüfnadel mit ihrer Spitze 26 auf der Kontaktstelle 12 aufsteht. In diesem Falle hat die Prüfnadel nach oben hin praktisch kein Spiel. Sie kann weder verloren gehen, noch durch "Ankleben" an der zu prüfenden Leiterplatte von dieser herausgezogen werden.

Die erfindungsgemäße Prüfnadel ist wesentlich kostengünstiger herzustellen als die bekannten Prüfnadeln und erbringt aufgrund ihrer Form auch bei der Montage eine Arbeitszeitersparnis von ca. 20% gegenüber herkömmlichen Prüfnadeln.

**Patentansprüche**

1. Prüfnadel für ein Prüfgerät zum Prüfen von Leiterplatten, umfassend einen Nadelschaft (28), mit einem Kopf (30), dadurch gekennzeichnet, daß der Kopf (30) von einem abgeflachten, ein scharfkantiges Kontaktprofil aufweisenden Endabschnitt des Nadelschaftes (28) gebildet ist.

2. Prüfnadel nach Anspruch 1, dadurch gekennzeichnet, daß der Kopf (30) in der zur Abflachungsrichtung senkrechten Richtung radial über den Nadelschaft (28) hinausragt.

3. Prüfnadel nach Anspruch 1 oder 2, dadurch gekennzeichnet, daß das Kontaktprofil mindestens eine unter einem von 90° verschiedenen Winkel zur Schaftachse gerichtete Kante (32) aufweist.

4. Prüfnadel nach Anspruch 3, dadurch gekennzeichnet, daß das Kontaktprofil von zwei unter einem Winkel dachartig gegeneinander geneigten Kanten (32) gebildet ist.

5. Prüfnadel nach Anspruch 4, dadurch gekennzeichnet, daß der Winkel zwischen den Kanten (32) ca. 120° beträgt.

6. Prüfnadel nach einem der Ansprüche 3 bis 5, dadurch gekennzeichnet, daß die Kanten (32) geradlinig sind.

7. Prüfnadel nach einem der Ansprüche 3 bis 5, dadurch gekennzeichnet, daß die Kanten (32) konkav gerümmt sind.

8. Prüfnadel nach einem der Ansprüche 3 bis 5, dadurch gekennzeichnet, daß die Kanten konvex gekrümmt sind.

9. Prüfnadel nach einem der Ansprüche 1 bis 4, dadurch gekennzeichnet, daß das Kontaktprofil mehrere Spitzen aufweist.

10. Prüfnadel nach einem der Ansprüche 1 bis 9, dadurch gekennzeichnet, daß der Kopf durch Prägen hergestellt ist.

11. Prüfnadel nach einem der Ansprüche 1 bis 10, dadurch gekennzeichnet, daß der Nadelschaft (28) in einem Abstand von dem Kopf (30) eine Verbreiterung (34), aufweist.

12. Prüfnadel nach Anspruch 11, dadurch gekennzeichnet, daß die Verbreiterung (34) ca. 20 % des Schaftdurchmessers beträgt.

13. Prüfnadel nach Anspruch 11 oder 12, dadurch gekennzeichnet, daß die Verbreiterung (34) durch Prägen hergestellt ist.

14. Prüfnadel nach Anspruch 11 oder 12, dadurch gekennzeichnet, daß die Verbreiterung (34) durch Stauchen des Nadelschaftes (28) hergestellt ist.

## Claims

1. Test probe for a test instrument for testing circuitboards, including a probe shank (28) with a head (30), characterized in that the head (30) is formed by a flattened end segment, showing a sharp-edged contact section, of the probe shank (28).

2. Test probe as claimed in Claim 1, characterized in that the head (30) juts out radially over the probe shank (28) in a direction perpendicular to the flattening direction.

3. Test probe as claimed in Claim 1 or 2, characterized in that the contact section shows at least one edge (32) directed at an angle different from 90° to the shank axis.

4. Test probe as claimed in Claim 3, characterized in that the contact section is formed by two edges (32) inclined to one another at an angle like a roof.

5. Test probe as claimed in Claim 4, characterized in that the angle between the edges (32) is about 120°.

6. Test probe as claimed in any one of Claims 3 to 5, characterized in that the edges (32) are straight.

7. Test probe as claimed in any one of Claims 3 to 5, characterized in that the edges (32) have a concave curvature.

8. Test probe as claimed in any one of Claims 3 to 5, characterized in that the edges have a convex curvature.

9. Test probe as claimed in any one of Claims 1 to 4, characterized in that the contact section shows a number of points.

10. Test probe as claimed in any one of Claims 1 to 9, characterized in that the head is formed by stamping.

11. Test probe as claimed in any one of Claims 1 to 10, characterized in that the probe shank (28) shows a broadening (34) at a distance from the head (30).

12. Test probe as claimed in Claim 11, characterized in that the broadening (34) amounts to about 20% of the shank diameter.

13. Test probe as claimed in Claim 11 or 12, characterized in that the broadening (34) is formed by stamping.

14. Test probe as claimed in Claim 11 or 12, characterized in that the broadening (34) is formed by upsetting the probe shank (28).

## Revendications

1. Aiguille de contrôle pour un appareil de contrôle destiné à contrôler des plaquettes de circuits imprimés, comportant une tige d'aiguille (28) munie d'une tête (30), caractérisée en ce que la tête (30) est constituée par la portion terminale aplatie de la tige d'aiguille (28) présentant un profil de contact à arêtes aiguës.

2. Aiguille de contrôle selon la revendication 1, caractérisée en ce que la tête (30) dépasse radialement au-delà de la tige d'aiguille (28) dans le sens perpendiculaire au sens de la partie aplatie.

3. Aiguille de contrôle selon la revendication 1 ou 2, caractérisée en ce que le profil de contact comporte au moins une arête (32) faisant avec l'axe de la tige d'aiguille un angle différent de 90°.

4. Aiguille de contrôle selon la revendication 3, caractérisée en ce que le profil de contact est constitué par deux arêtes (32) inclinées l'une vers l'autre en faisant un angle en forme de toit.

5. Aiguille de contrôle selon la revendication 4, caractérisée en ce que l'angle entre le arêtes (32) est d'environ 120°.

6. Aiguille de contrôle selon l'une des revendications 3 à 5, caractérisée en ce que les arêtes (32) sont rectilignes.

7. Aiguille de contrôle selon l'une des revendications 3 à 5, caractérisée en ce que les arêtes (32) ont une courbure concave.

8. Aiguille de contrôle selon l'une des revendications 3 à 5, caractérisée en ce que les arêtes ont une courbure convexe.

9. Aiguille de contrôle selon l'une des revendications 1 à 4, caractérisée en ce que le profil de contact comporte plusieurs pointes.

10. Aiguille de contrôle selon l'une des revendications 1 à 9, caractérisée en ce que la tête est fabriquée par matriçage.

11. Aiguille de contrôle selon l'une des revendications 1 à 10, caractérisée en ce que la tige d'aiguille (28) comporte une partie élargie (34) située à une certaine distance de la tête (30).

12. Aiguille de contrôle selon la revendication 11, caractérisée en ce que la partie élargie (34) correspond à environ 20% du dispositif de la tige d'aiguille.

13. Aiguille de contrôle selon la revendication 11 ou 12, caractérisée en ce que la partie élargie (34) est fabriquée par matriçage.

14. Aiguille de contrôle selon la revendication 11 ou 12, caractérisée en ce que la partie élargie (34) est fabriquée par refoulement de la tige d'aiguille (28).

FIG. 1

FIG. 2

FIG. 3

FIG. 4

FIG. 5

(a)

(b)

(c)

—34

34—

34—

FIG. 6

FIG. 7

34—

(a)

34—

FIG.8

(b)

34—

(a)

(b)

(c)

34—

34—

34—

FIG.9

FIG. 10

34

FIG. 11

34

(a)

(b)

(c)

34

34

34

FIG. 12

(a)

(b)

(c)

34

34

34

FIG. 13

(a)  (b)  (c)

34

**FIG. 14**

(a)  (b)  (c)

34

**FIG.15**